# EUROPÄISCHE PATENTSCHRIFT

(11) **EP 0 806 109 B1**
(45) Veröffentlichungstag und Bekanntmachung des Hinweises auf die Patenterteilung: **10.06.1998**
(21) Anmeldenummer: 96906764.4
(22) Anmeldetag: 13.03.1996
(51) Int. Cl.: H04N 5/335, G01J 1/46

(54) **STRAHLUNGSSENSOREINRICHTUNG ZUM ERFASSEN DER HÄUFIGKEIT EINER AUF DIESER AUFTREFFENDEN STRAHLUNG**
RADIATION SENSOR ARRANGEMENT FOR DETECTING THE FREQUENCY OF RADIATION IMPINGING THEREON
DISPOSITIF DE DETECTION DE RAYONNEMENT PERMETTANT DE DETECTER LA FREQUENCE D'UN RAYONNEMENT FRAPPANT LEDIT DISPOSITIF

(30) Priorität: 20.03.1995 DE 19510070
(43) Veröffentlichungstag der Anmeldung: 12.11.1997
(73) Patentinhaber: SARAD GESELLSCHAFT FÜR KOMPLEXE LEISTUNGEN ZUR SANIERUNG RADIOLOGISCH BELASTETER OBJEKTE MBH, 01705 Freital (DE)
(72) Erfinder: STREIL, Thomas, Dr., D-01169 Dresden (DE); KLINKE, Roland, D-44225 Dortmund (DE)
(74) Vertreter: Schoppe, Fritz, Dipl.-Ing.
(86) Internationale Anmeldenummer: EP9601074
(87) Internationale Veröffentlichungsnummer: WO9629820

(56) Entgegenhaltungen:
- DE-C- 4 224 358
- US-A- 4 764 814
- IEEE INTERNATIONAL SOLID STATE CIRCUITS CONFERENCE, Bd. 35, 1.Februar 1992, Seiten 168-169, 275, XP000315804 KAZUO MIWADA ET AL: "A 100MHZ DATA-RATE, 5000-ELEMENT CCD LINEAR IMAGE SENSOR WITH RESET PULSE LEVEL ADJUSTMENT CIRCUIT"

## Beschreibung

Die vorliegende Erfindung bezieht sich auf eine Strahlungssensoreinrichtung, und insbesondere auf eine Strahlungssensoreinrichtung zum Erfassen der Häufigkeit einer auf diese auftreffenden Strahlung.

Im Stand der Technik sind bereits Strahlungssensoreinrichtungen bekannt, die beispielsweise zur Erfassung einer Quantenstrahlung dienen. Ein Nachteil derartiger Sensoren besteht darin, daß beim Erfassen von Strahlungen, die relativ selten und punktförmig auftreten, besondere Probleme auftreten. Aufgrund der geringen Ereigniswahrscheinlichkeit ist eine große Sensorfläche notwendig, um die Ereignisse erfassen zu können. Andererseits wird das punktförmige Ereignis durch die große Fläche gemittelt und die Sensoren verlieren an Empfindlichkeit und der Signal-Rausch-Abstand verschlechtert sich.

Dieses Problem kann durch Verwenden einer Mehrzahl von Einzelelementen, die in einer Matrix angeordnet sind, gelöst werden.

Diese Art der Anordnung der Einzelelemente in einer Matrix weist jedoch ebenfalls erhebliche Probleme auf. Diese Probleme treten beim Auslesen der Matrixelemente auf, die die punktförmige Strahlung, die mit einer geringen Wahrscheinlichkeit auftritt, erfassen. Durch eine sogenannte systematische Adressierung ist jeweils ein vollständiger Adressierungszyklus der gesamten Matrix notwendig. Als Ergebnis erhält man sowohl die Adresse als auch den Wert des aktiven Matrixelements, das im allgemeinen als Pixel bezeichnet wird.

Ein besonderer Nachteil besteht bei Anwendungen, bei denen lediglich die Ereignisse, d.h. die Häufigkeit einer auftreffenden Strahlung, erfaßt wird. In diesem Fall liefert diese Adressierungsart zu einem sehr großen Anteil keine verwertbaren Informationen.

Ein weiteres Problem, das bei diesen Anwendungen auftritt, besteht darin, daß die Reaktionsgeschwindigkeit einzelner Sensorelemente wesentlich größer sein kann als der Systemtakt für die gesamte Sensorelementmatrix. Reaktionsgeschwindigkeit bedeutet in diesem Zusammenhang diejenige Geschwindigkeit, mit der die durch die einfallende Strahlung generierten Ladungsträger in dem Strahlungssensorelement abgebaut werden. Dieser Abbau wird im allgemeinen Rekombination genannt. Ein Problem tritt dann auf, wenn beim erneuten Durchlauf des Systemtaktes die Reaktionszeit des Sensors, die durch die Reaktionsgeschwindigkeit bestimmt wird, nach einem vorherigen Strahlungseinfall noch nicht abgelaufen ist. In diesem Fall gibt der Sensor ein Signal aus, von dem nicht bekannt ist, ob es durch eine erneut auftreffende Strahlung auf den Sensor oder durch noch nicht vollständig rekombinierte Ladungsträger erzeugt wurde.

Die DE-4224358 C1 beschreibt eine Strahlungssensoreinrichtung, die eine hohe Sensitivität und einen hohen Dynamikbereich aufweist und die zur Erfassung von Quantenstrahlung dient. Bei der Erfassung der Häufigkeit einer auftreffenden Strahlung mittels einer solchen bekannten Strahlungssensoreinrichtung treten die oben beschriebenen Probleme bezüglich der Reaktionsgeschwindigkeit und bezüglich des Systemtaktes beim Auslesen der Strahlungssensoreinrichtung auf.

Die DE 41 18 154 Al beschreibt eine Anordnung mit einer Sensormatrix und einer Rücksetzanordnung. Diese bekannte Anordnung umfaßt eine Mehrzahl von in einer Matrix angeordneten licht- bzw. röntgenstrahlenempfindlichen Sensoren, die in Abhängigkeit der auftreffenden Strahlungsmenge Ladungen erzeugen. Die Sensoren umfassen jeweils einen elektrischen Schalter. Je Sensorzeile weist die Anordnung eine Schaltleitung auf, über die die einzelnen Schalter aktivierbar sind, so daß die erzeugten Ladungen über zugeordnete Ausleseleitungen abfließen. Zur Beseitigung von Rest ladungen nach einem Auslesevorgang umfaßt die Anordnung eine Rücksetzanordnung, die die Sensoren nach dem Auslesen über deren Ausleseleitung aktiviert, wodurch die elektrischen Schalter der Sensoren leitend werden und, die in den Sensoren nach dem zuvor erfolgten Auslesevorgang gespeicherten Rest ladungen über die zugeordneten Ausleseleitungen abfließen. Nach einer vorbestimmten Anzahl von Takten eines Rücksetztaktes werden die entsprechenden Ausleseleitungen wieder deaktiviert.

Ausgehend von diesem Stand der Technik liegt der vorliegenden Erfindung die Aufgabe zugrunde, eine Strahlungssensoreinrichtung dahingehend weiter zu entwickeln, daß diese eine verbesserte Reaktionsgeschwindigkeit aufweist.

Diese Aufgabe wird durch eine Strahlungssensoreinrichtung gemäß Anspruch 1 gelöst.

Die vorliegende Erfindung schafft eine Strahlungssensoreinrichtung zum Erfassen der Häufigkeit einer auf dieser auftreffenden Strahlung, mit zumindest einem Strahlungssensorelement, das einen durch die auftreffende Strahlungsleistung erzeugten Strom abgibt; und eine Erfassungsschaltung, die den vom Strahlungssensorelement erzeugten Strom erfaßt; wobei eine Rücksetzschaltung vorgesehen ist, die derart mit dem Strahlungssensorelement verbunden ist, daß die durch die auftreffende Strahlungsleistung erzeugten Ladungsträger bei Ansteuerung der Rücksetzschaltung mit einem Rücksetzsignal mit einer Rate rekombinieren, die höher ist als die Rate ohne Rücksetzsignal, wobei das Rücksetzsignal durch die Erfassungsschaltung an die Rücksetzschaltung anlegbar ist.

Gemäß einer vorteilhaften Weiterbildung der vorliegenden Erfindung werden die einzelnen Matrixelemente abhängig vom Ausleseergebnis und der Anzahl der adressierten Matrixelemente zurückgesetzt. Dies wird durch eine Sensoreinrichtung erreicht, bei der die Erfassungsschaltung folgende Merkmale umfaßt: einen Kondensator, der zwischen einen Ausgang des Strahlungssensorelements und Masse geschaltet ist; einen Schalter, der in seinem geschlossenen Zustand den Kondensator überbrückt; einen Puffer, dessen Eingang mit dem Ausgang des Strahlungssensorelements verbunden ist; einen Analog/Digital-Wandler, dessen Eingang mit dem Ausgang des Inverters verbunden ist; eine Logikschaltung mit einem Eingang und drei Ausgängen, deren Eingang mit dem Ausgang des Analog/Digital-Wandlers verbunden ist, die abhängig von am Eingang anliegenden Signalen am ersten und zweiten Ausgang das Rücksetzsignal erzeugt und am dritten Ausgang ein Ausgangssignal erzeugt, wobei der erste Ausgang mit der Rücksetzschaltung verbunden ist, und der zweite Ausgang mit dem Schalter verbunden ist; und eine Flagspeichereinrichtung, die mit dem dritten Ausgang der Logikschaltung verbunden ist und die abhängig vom Ausgangssignal der Logikschaltung und aus einem Vergleich eines vorhergehenden Wertes des Ausgangssignals mit dem anliegenden Ausgangssignal einen Zustand einer Flag einstellt und speichert.

Gemäß einer weiteren bevorzugten Ausführung schafft die vorliegende Erfindung eine intelligente Adressierung, die durch eine Strahlungssensoreinrichtung erreicht wird, bei der die Erfassungsschaltung folgende Merkmale aufweist: eine erste Einrichtung, die zwischen einem Ausgang des Strahlungssensorelements und Masse geschaltet ist, die ein erstes vom Strahlungssensorelement abgegebenes Signal mit einem ersten Pegel auf Masse leitet, und für ein zweites vom Strahlungssensorelement abgegebenes Signal mit einem zweiten Pegel sperrt, wobei der zweite Pegel höher ist als der erste Pegel; eine zweite Einrichtung, die mit dem Ausgang des Strahlungssensorelements verbunden ist und für das erste Signal sperrt und für das zweite Signal leitet; und einen Puffer, der mit dem Ausgang der zweiten Einrichtung verbunden ist, und dessen Ausgang mit einem Ausgang der Erfassungsschaltung verbunden ist.

Weitere bevorzugte Weiterbildungen der vorliegenden Erfindung sind in den Unteransprüchen definiert.

Anhand der beiliegenden Zeichnungen werden nachfolgend bevorzugte Ausführungsbeispiele der vorliegenden Erfindung näher erläutert. Es zeigen:
- Fig. 1: ein erstes Ausführungsbeispiel der erfindungsgemäßen Strahlungssensoreinrichtung;
- Fig. 2: ein zweites Ausführungsbeispiel der erfindungsgemäßen Strahlungssensoreinrichtung;
- Fig. 3: ein drittes Ausführungsbeispiel der erfindungsgemäßen Strahlungssensoreinrichtung;
- Fig. 4: ein viertes Ausführungsbeispiel der erfindungsgemäßen Strahlungssensoreinrichtung; und
- Fig. 5a und 5b: ein fünftes und ein sechstes Ausführungsbeispiel der erfindungsgemäßen Strahlungssensoreinrichtung.

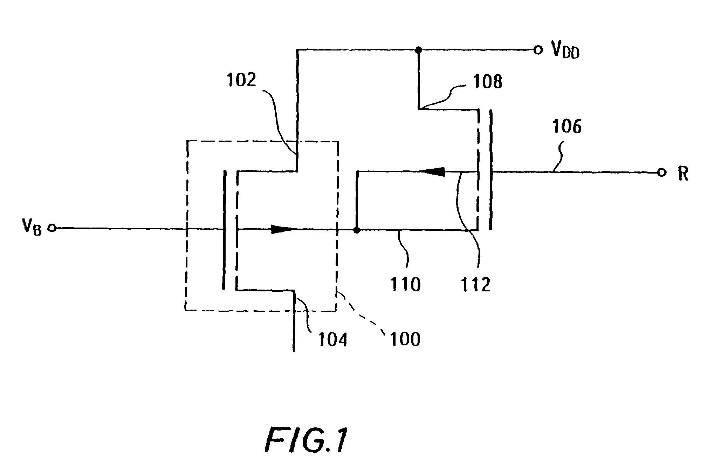

Anhand der Fig. 1 wird nachfolgend ein erstes Ausführungsbeispiel der vorliegenden Erfindung näher beschrieben.

Die in Fig. 1 dargestellte Sensoreinrichtung umfaßt ein Strahlungssensorelement, das in seiner Gesamtheit mit dem Bezugszeichen 100 versehen ist. Bei dem in Fig. 1 dargestellten Ausführungsbeispiel ist dieses Strahlungssensorelement 100 beispielsweise ein MOS-Transistor, der eine sogenannte floatende Wanne aufweist.

Es ist offensichtlich, daß die vorliegende Erfindung nicht auf solche Strahlungssensorelemente beschränkt ist, sondern daß eine Vielzahl von Strahlungssensorelementen in Frage kommen, wie beispielsweise ein J-FET oder ein SOI-Transistor.

Der Drain-Source-Strom des Transistors 100 ist im wesentlichen proportional zu der einfallenden Strahlungsleistung. Ein Sourceanschluß 102 des Transistors 100 wird mit einem Versorgungspotential V_{DD} beaufschlagt, während der Arbeitspunkt des Transistors über eine Arbeitspunkteinstellspannung V_{B} einstellbar ist. An einem Drainanschluß 104 des Transistors 100 ist das durch den Transistor 100 erzeugte Signal abgreifbar.

Das am Drainanschluß 104 abgegriffene Ausgangssignal wird einer Erfassungsschaltung zugeführt (in Fig. 1 nicht dargestellt), die den vom Strahlungssensorelement erzeugten Strom erfaßt und weiter verarbeitet.

Die in Fig. 1 dargestellte Strahlungssensoreinrichtung umfaßt neben dem Transistor 100 eine Rücksetzschaltung, die bei dem in Fig. 1 dargestellten Ausführungsbeispiel ein FET-Schalter ist.

Der FET-Schalter umfaßt einen Gate-Anschluß 106, einen Sourceanschluß 108, einen Drainanschluß 110 und einen mit dem Drainanschluß 110 verbundenen Substratanschluß 112.

Der Sourceanschluß 108 wird mit dem Versorgungspotential V_{DD} beaufschlagt.

An den Gate-Anschluß 106 ist ein Rücksetzsignal R anlegbar, das durch die Erfassungsschaltung (nicht dargestellt) erzeugt wird.

Durch das Anlegen des Rücksetzsignals an das Gate des FET-Schalters wird dieser leitend, so daß die durch die auftreffende Strahlungsleistung im Strahlungssensorelement erzeugten Ladungsträger mit einer Rate rekombinieren, die höher ist als die Rate, die ohne Rücksetzsignal angetroffen wird.

Durch diese Erhöhung der Rekombinationsrate im Strahlungssensorelement ist es möglich, die Reaktionsgeschwindigkeit des Strahlungssensorelements zu verbessern, so daß die Reaktionszeit abnimmt.

Ist das Strahlungssensorelement 100 ein MOS-Transistor mit floatender Wanne, so kann die Rücksetzschaltung in dieser Wanne angeordnet sein, wodurch sich der Vorteil ergibt, daß die Rücksetzschaltung kein Teil der aktiven Fläche der Strahlungssensoreinrichtung ist.

Die vorliegende Erfindung ist nicht auf FET-Schalter beschränkt, sondern es ist im wesentlichen jede beliebige Art einer Rücksetzschaltung verwendbar, durch die es ermöglicht wird, die Rekombinationsrate durch Anlegen eines Rücksetzsignals gegenüber der Rekombinationsrate ohne Rücksetzsignal zu erhöhen.

Obwohl in Fig. 1 lediglich ein Strahlungssensorelement mit einer Rücksetzschaltung dargestellt ist, ist es offensichtlich, daß die Erfindung nicht nur auf dieses Einzelelement beschränkt ist, sondern ebenfalls die Verschaltung einer Mehrzahl solcher Strahlungssensorelemente mit Rücksetzschaltung in einer Matrix einschließt.

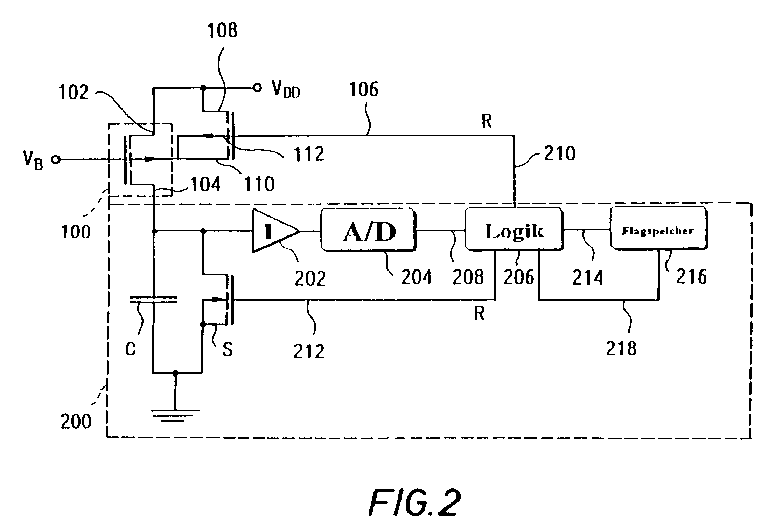

In Fig. 2 ist ein weiteres Ausführungsbeispiel der vorliegenden Erfindung beschrieben, wobei für Elemente, die bereits in Fig. 1 gezeigt sind, gleiche Bezugszeichen verwendet werden. Eine erneute Beschreibung dieser Elemente wird weggelassen.

Neben dem bereits anhand von Fig. 1 beschriebenen Strahlungssensorelement 100 mit Rücksetzschaltung zeigt die Fig. 2 ein Ausführungsbeispiel einer Erfassungsschaltung, die in ihrer Gesamtheit mit dem Bezugszeichen 200 bezeichnet ist.

Diese Erfassungsschaltung 200 umfaßt einen Kondensator C, der zwischen den Ausgang 104 des Strahlungssensorelements 100 und Masse geschaltet ist. Ein Schalter S liegt parallel zu dem Kondensator C und überbrückt diesen in seinem geschlossenen Zustand. Bei dem in Fig. 2 dargestellten Ausführungsbeispiel handelt es sich bei dem Schalter S um einen an sich bekannten FET-Schalter. Die Darstellung dieses FET-Schalters ist lediglich beispielhaft, andere Schaltereinrichtungen können anstelle des FET-Schalters ohne weiteres verwendet werden.

Der Ausgang 104 des Strahlungssensorelements 100 ist mit einem Eingang eines Puffers 202 verbunden, dessen Ausgang mit dem Eingang eines Analog/Digital-Wandlers 204 verbunden ist. Eine Logikschaltung 206 umfaßt einen Eingang 208, der mit dem Ausgang des Analog/Digital-Wandlers 204 verbunden ist, und drei Ausgänge 210, 212 und 214. Abhängig von am Eingang 208 anliegenden Signalen erzeugt die Logikschaltung 206 am ersten Ausgang 210 und am zweiten Ausgang 212 das Rücksetzsignal R. Der Ausgang 210 der Logikschaltung 206 ist mit dem Gate-Anschluß 106 der Rücksetzschaltung verbunden, und der Ausgang 212 der Logikschaltung 206 ist mit dem Gate-Anschluß des Schalters S verbunden. Die Logikschaltung 206 erzeugt an ihrem dritten Ausgang 214 ein Ausgangssignal, das in einen Flagspeicher 216 eingegeben wird. Abhängig von dem auf der Leitung 214 anliegenden Ausgangssignal der Logikschaltung 206 und aus einem Vergleich eines vorhergehenden Wertes des Ausgangssignals mit dem anliegenden Ausgangssignal wird ein Zustand einer Flag in dem Flagspeicher 216 eingestellt und gespeichert. Der Vergleich eines vorhergehenden Wertes des Ausgangssignals erfolgt über die Leitung 218, die einen Ausgang des Flagspeichers mit einem weiteren Eingang der Logikschaltung 206 verbindet.

Die Logikschaltung 206 ist wirksam, daß das Matrixelement (Pixel) nur zurückgesetzt wird, wenn das Ergebnis gültig ist oder das Pixel in dem vorherigen Zyklus nicht zurückgesetzt wurde. Die nachfolgende Tabelle verdeutlicht den verwendeten Algorithmus:

**Tabelle 1**

| Ergebnis der A/D-Umwandlung | Alter Wert der Auslese-Flag | Neuer Wert der Auslese-Flag | Ergebnis |
|---|---|---|---|
| Minimum oder Maximum | beliebig | 0 | gültig |
| anderes Digitalwort | 0 | 1 | ungültig |
| anderes Digitalwort | 1 | 0 | gültig |

Durch diesen Algorithmus wird erreicht, daß unabhängig vom Eintreffen eines Ereignisses - dem Auftreffen einer Strahlung auf einem Sensorelement - mindestens eine Systemperiode verstreicht. Deshalb ist eine Verfälschung des Ergebnisses nicht zu erwarten.

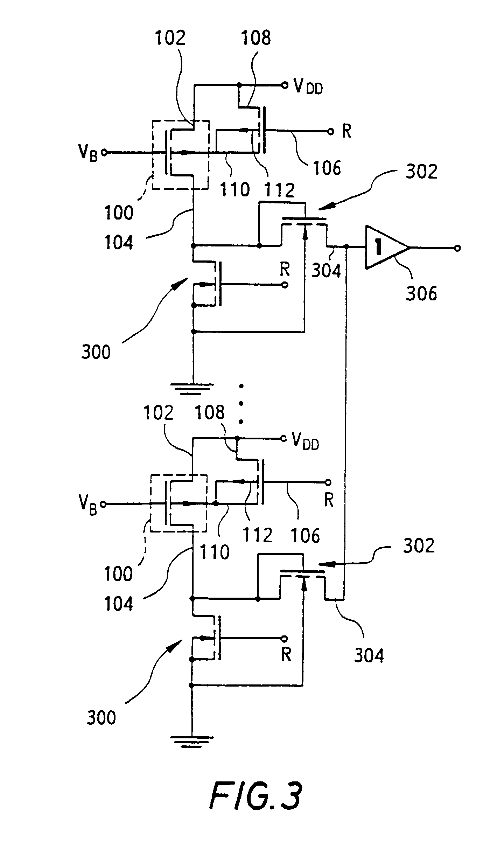

Anhand von Fig. 3 wird nachfolgend ein drittes Ausführungsbeispiel der vorliegenden Erfindung beschrieben. Auch hier sind Elemente, die bereits anhand von Fig. 1 beschrieben wurden, mit den gleichen Bezugszeichen versehen, und eine erneute Beschreibung wird weggelassen.

Fig. 3 zeigt eine sogenannte intelligente Adressierung, durch die eine Adressierung auf der Chipoberfläche eingespart werden kann. Der Vorteil besteht darin, daß auf der Sensoroberfläche im wesentlichen nur aktive Fläche zurückbleibt. In Fig. 3 ist ein Teil einer Erfassungsschaltung dargestellt.

Obwohl in Fig. 3 zwei Strahlungssensorelemente mit der entsprechenden Erfassungsschaltung dargestellt sind, wird lediglich eine dieser Erfassungsschaltungen beschrieben, da diese jeweils gleich sind.

Die Erfassungsschaltung in Fig. 3 umfaßt einen ersten Transistor 300, die zwischen den Ausgang des Strahlungssensorelements 104 und Masse geschaltet ist, sowie einen zweiten Transistor 302, der mit dem Ausgang des Strahlungssensorelements 104 verbunden ist.

Die Transistoren 300, 302 gewährleisten, daß während der Rücksetzphase die Signale am Ausgang 104 des Strahlungssensorelements 100 auf Masse liegen.

Während der Meßphase wird genau das Signal am Ausgang 304 erscheinen, das den höchsten Pegel aufweist.

Das in Fig. 3 dargestellte Ausführungsbeispiel weist eine Mehrzahl solcher Erfassungsschaltungen auf, deren Ausgänge 304 jeweils mit dem Eingang eines Puffers 306 verbunden sind, dessen Ausgang mit einem weiteren, nicht dargestellten Teil einer Erfassungsschaltung verbunden ist.

Über diese nicht dargestellte Erfassungsschaltung ist an den ersten Transistor ein Rücksetzsignal anlegbar.

Durch diese intelligente Adressierung wird es ermöglicht, daß das Pixel, bei dem das Signal anlegt, immer das Ausgangssignal bestimmt. Sobald ein Wert ausgelesen wurde oder eine vorbestimmte Zeit abgelaufen ist, wird das Rücksetzsignal ausgegeben.

Bei dem in Fig. 3 dargestellten Ausführungsbeispiel muß nicht mehr jedes Pixel einzeln adressiert werden.

Der erste Transistor 300 ist als NMOS-Transistor ausgeführt, dessen Source mit dem Ausgang 104 des Strahlungssensorelements 100 verbunden ist, dessen Drain mit Masse verbunden ist, und an dessen Gate das Rücksetzsignal anlegbar ist. Der zweite Transistor 302 ist ein NMOS-Transistor, der in der sogenannten Diodenschaltung verschaltet ist.

Es ist offensichtlich, daß neben den gerade beschriebenen NMOS-Transistoren auch andere Schaltungselemente zur Realisierung des ersten Transistors 300 und des zweiten Transistors 302 möglich sind.

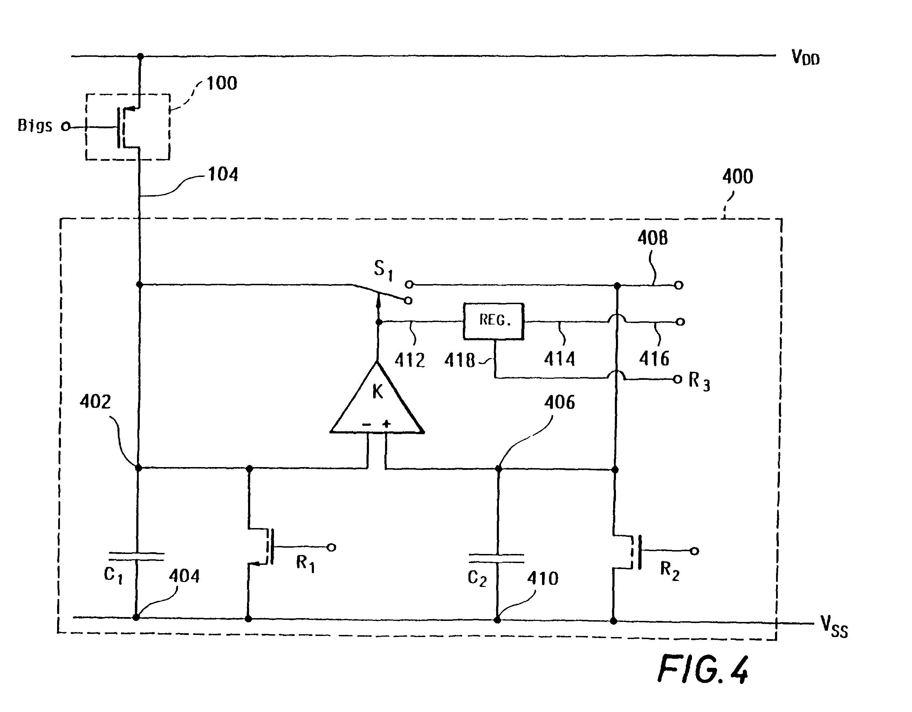

Anhand von Fig. 4 wird nachfolgend ein viertes Ausführungsbeispiel der vorliegenden Erfindung beschrieben. Auch hier sind Elemente, die bereits anhand von Fig. 1 beschrieben wurden, mit den gleichen Bezugszeichen versehen, und eine erneute Beschreibung wird weggelassen.

Die Erfassungsschaltung 400 bei dem Ausführungsbeispiel in Fig. 4 umfaßt einen ersten Speicherkondensator C₁, dessen erster Anschluß 402 mit dem Ausgang 104 des Stahlungssensorelements 100 verbunden ist, und dessen zweiter Anschluß 404 mit einer Leistungsversorgung Vₛₛ verbunden ist.

Parallel zu dem ersten Speicherkondensator ist ein erster Rücksetzschalter R₁ geschaltet.

Die Erfassungsschaltung 400 umfaßt ferner einen zweiten Speicherkondensator C₂, dessen erster Anschluß 406 mit einem Ausgang 408 der Erfassungsschaltung 400 verbunden ist, und dessen zweiter Anschluß 410 mit der Leistungsversorgung Vₛₛ verbunden ist.

Parallel zu dem zweiten Speicherkondensator ist ein zweiter Rücksetzschalter R₂ geschaltet.

Die Rücksetzschalter R₁ und R₂ sind in diesem Ausführungsbeispiel FET-Schalter.

Ein invertierender Eingang eines Komparators K ist mit dem ersten Anschluß 402 des ersten Speicherkondensators C₁ verbunden, und ein nicht-invertierender Anschluß des Komparators K ist mit dem ersten Anschluß 406 des zweiten Speicherkondensators C₂ verbunden.

Ein Schalter S₁ ist zwischen den Ausgang 104 des Strahlungssensorelements 100 und den Ausgang 408 der Erfassungsschaltung 400 geschaltet. Der Schalter ist durch ein Signal am Ausgang des Komparators K gesteuert und verbindet in seinem geschlossenen Zustand den Ausgang 104 und den Ausgang 408.

Der Ausgang des Komparators ist mit einem Eingang 412 eines Registers REG verbunden. Ein Ausgang 414 des Registers REG ist mit einem Ausleseanschluß 416 der Erfassungsschaltung 400 verbunden. Ein Rücksetzeingang 418 des Registers REG ist mit einem Rücksetzanschluß R₃ verbunden.

Nachfolgend wird die Funktionsweise der Erfassungsschaltung 400 näher beschrieben.

Zu einem Zeitpunkt t₀ wird ein Ausgangssignal des Strahlungssensorelements 100 auf dem Speicherkondensator C₂ gespeichert. Danach wird das Strahlungssensorelement 100 zurückgesetzt.

Während der Meßzeit wird das Ausgangssignal des Strahlungssensorelements 100 auf dem Speicherkondensator C₁ gespeichert.

Nach Abschluß der Meßzeit wird der Speicherkondensator C₁ mittels des ersten Rücksetzschalters R₁ entladen.

Durch den Komparator werden die Spannungen an den Speicherkondensatoren C₁ und C₂ verglichen. Falls die Spannung am Speicherkondensator C₁ größer ist als diejenige am Speicherkondensator C₂ wird am Ausgang des Komparators ein Signal erzeugt.

Dieses Signal bewirkt ein Schließen des Schalters S₁, der zu Beginn der Meßzeit offen ist. Gleichzeitig wird ein Auslesebit in das Register REG geschrieben.

Ist die Spannung am Speicherkondensator C₁ kleiner ist als diejenige am Speicherkondensator C₂ wird am Ausgang des Komparators kein Signal erzeugt, der Schalter S₁ bleibt offen, und in das Register REG wird kein Auslesebit geschrieben.

Das Auslesen aus der Erfassungsschaltung 400 wird nur in dem Fall durchgeführt, in dem das Auslesebit gesetzt ist. Ist das Auslesen abgeschlossen, erfolgt ein Zurücksetzen des Auslesebits durch ein Rücksetzsignal, das am Rücksetzanschluß R₃ anliegt. Das Auslesen wird durch eine am Ausgang 408 der Erfassungsschaltung 400 angeordnete Verarbeitungsschaltung (nicht dargestellt) gesteuert.

Nach dem Ende der Meßzeit werden beide Speicherkondensatoren vor einer erneuten Messung mittels der Rücksetzschalter R₁ und R₂ zurückgesetzt.

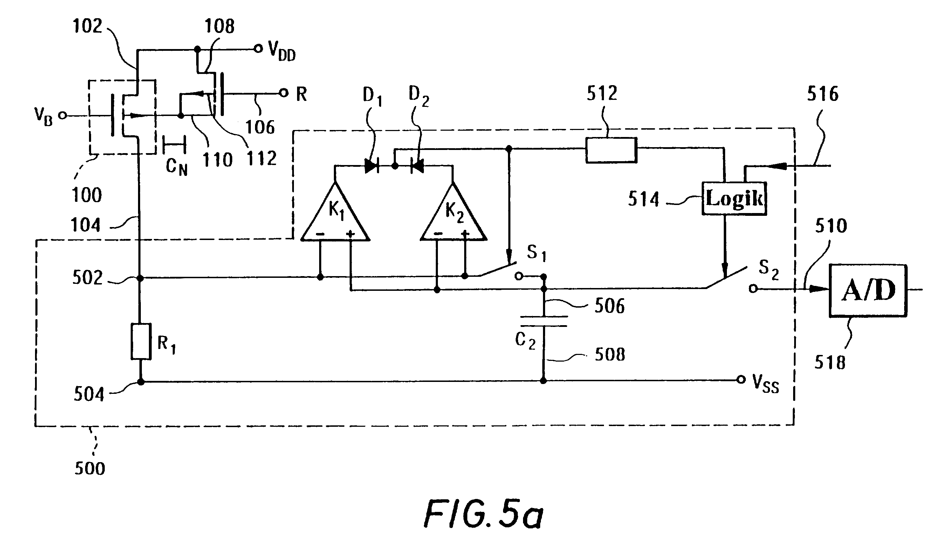

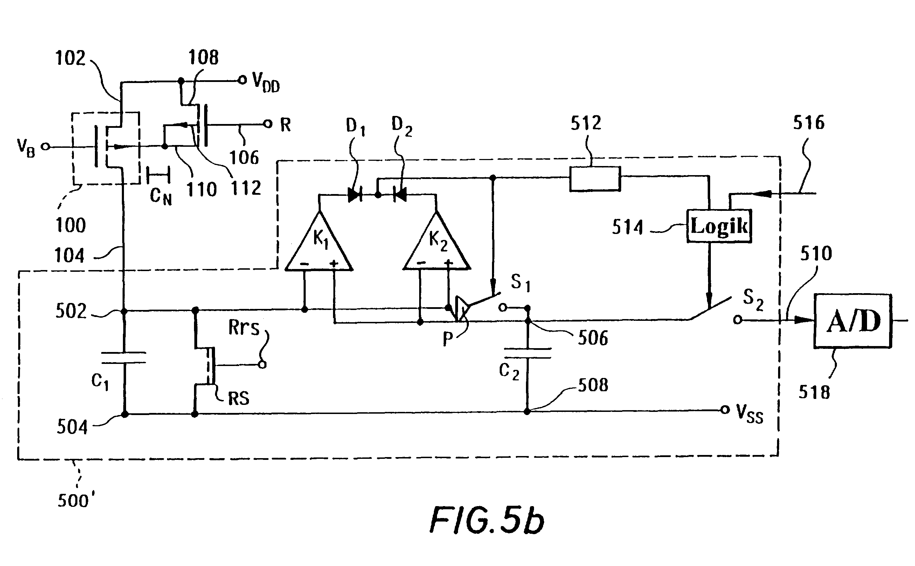

Anhand der Fig. 5a und 5b werden nachfolgend ein fünftes und ein sechstes Ausführungsbeispiel der vorliegenden Erfindung beschrieben. Die bereits anhand von Fig. 1 beschriebenen Elemente sind mit den gleichen Bezugszeichen versehen und eine erneute Beschreibung dieser Elemente erfolgt nicht.

Bei dem fünften und sechsten Ausführungsbeispiel dient als Speicher für die am die Strahlungssensorelement 100 eingefallene Strahlung die Eigenkapazität Cₙ des Strahlungssensorelements 100, wie es in Fig. 5a und 5b dargestellt ist.

Bei den in Fig. 5a und 5b dargestellten Ausführungsbeispielen ist diese Eigenkapazität Cₙ die N-Wannenkapazität des P-MOS Phototransistors. Die in der N-Wanne gesammelten Ladungen, die von der Strahlung erzeugt werden, erzeugen einen proportionalen Drain-Source-Strom (Ladungs-Stromwandlung).

Die Erfassungsschaltung 500 bei dem in Fig. 5a dargestellten Ausführungsbeispiel umfaßt einen Widerstand R₁, dessen erster Anschluß 502 mit dem Ausgang 104 des Strahlungssensorelements verbunden ist, und dessen zweiter Anschluß 504 mit einer Leistungsversorgung Vₛₛ verbunden ist.

Der Widerstand R₁ ist mit seinem ersten Anschluß 502 mit einem invertierenden Anschluß eines ersten Komparators K₁ und mit einem nicht-invertierenden Anschluß eines zweitem Komparators K₂ verbunden. Über einen ersten Schalter S₁ ist der erste Anschluß 502 des Widerstands R₁ mit einem ersten Anschluß 506 eines Speicherkondensators C₂ verbunden.

Der Speicherkondensator C₂ hat einen zweiten Anschluß 508, der mit der Leistungsversorgung Vₛₛ verbunden ist.

Der Speicherkondensator C₂ ist mit seinem ersten Anschluß 506 mit einem nicht-invertierenden Anschluß des Komparators K₁ und mit einem invertierenden Anschluß des Komparators K₂ verbunden.

Der Speicherkondensator C₂ ist mit seinen ersten Anschluß 506 über einen zweiten Schalter S₂ mit einem Ausgang 510 der Erfassungsschaltung 500 verbunden.

Die Ausgänge der Komparatoren K₁, K₂ sind über zwei Dioden D₁ und D₂ miteinander verbunden. Zwischen den Dioden D₁ und D₂ ist das Ausgangssignal der Komparatoren K₁, K₂ abgreifbar. Mittels dieses Ausgangssignals ist der ersten Schalter S₁ steuerbar.

Über eine verzögerungsschaltung 512 und eine Logikschaltung 514 ist das Ausgangssignal der Komparatoren K₁, K₂ an den zweiten Schalter S₂ zu dessen Steuerung anlegbar. Die Logikschaltung 514 erhält über einen Anschluß 516 ein externes Steuersignal.

Über einen A/D-Wandler 518 ist der Ausgang der Erfassungsschaltung mit einem Datenbus (nicht dargestellt) verbunden.

Es folgt nun eine kurze Beschreibung der Funktionsweise des in Fig. 5a dargestellten Ausführungsbeispiels.

Der vom Strahlungssensorelement 100 erzeugte Strom wird am Widerstand R₁ als Spannungsabfall registriert. Der Doppelkomparator K₁, K₂ vergleicht die Spannungen am Widerstand R₁ und am Speicherkondensator C₂. Wenn beide Spannungen gleich sind, wird der erste Schalter S₁ nicht geschlossen und an den zweiten Schalter S₂ wird kein Ausgangssignal zur Impulshöhenverarbeitung gesandt.

Ist die Spannung größer oder kleiner als die eingestellte Komparatordifferenz, wird der erste Schalter S₁ geschlossen und der Speicherkondensator C₂ wird auf das Potential am Widerstand R₁ geladen. Etwas zeitverzögert, bis der Ladevorgang abgeschlossen ist, wird das Ausgangssignal über den zweiten Schalter S₂ an den A/D-Wandler 518 und an den Datenbus geleitet.

Nach Abschluß der A/D-Wandlung, wird der zweite Schalter S₂ und der ersten Schalter S₁ geöffnet und der Speicherkondensator C₂ speichert die Ladung.

Das Strahlungssensorelement 100 und dessen Eigenkapazität Cₙ werden anschließend zurückgesetzt.

Dieser Vorgang läuft während eines definiertem Taktzyklus ab.

Das in Fig. 5b dargestellte sechste Ausführungsbeispiel stimmt im wesentlichen mit dem in Fig. 5a dargestellten Ausführungsbeispiel überein.

Anstelle des Widerstands R₁ wird bei der Erfassungsschaltung 500' gemäß diesem Ausführungsbeispiel ein erster Speicherkondensator C₁ verwendet, zu dem parallele ein Rücksetzschalter RS geschaltet ist, an den ein Rücksetzsignal Rᵣₛ anlegbar ist.

Ferner ist zwischen dem nicht-invertierenden Eingang des Komparators K₂ und dem ersten Schalter S₁ ein Puffer P vorgesehen, der eine Verstärkung von Eins hat.

Während des definierten Taktzyklus, wird der erste Speicherkondensator C₁ durch den aus dem Strahlungseinfall resultierenden Stromfluß aufgeladen. Zu definierten Zeitabständen werden die Ladungen auf dem ersten Speicherkondensator C₁ und dem Speicherkondensator C₂ verglichen.

Sind beide Ladungen gleich, wird kein Ausgangssignal an den Ausgang 510 abgegeben. Im Falle, daß von einer der Erfassungsschaltung 500' nachgeschalteten Verarbeitungseinheit ein Ausgangssignal angefordert wird, wird das Ausgangssignal mittels einer entsprechenden Ansteuerung der Logikschaltung 514, die daraufhin den zweiten Schalter S₂ schließt, an den Ausgang 510 geleitet.

Ist die Ladung unterschiedlich, so wird der Schalter S₁ geschlossen und die Ladung wird über den Puffer P und dessen niederohmigem Ausgang vom ersten Speicherkondensator C₁ auf den Speicherkondensator C₂ umgeladen.

Um eine durch die Verzögerungsschaltung 512 verzögerte Zeit, nachdem der Umladevorgang abgeschlossen ist, wird der Speicherkondensator C₂ mittels des zweiten Schalter S₂ mit dem Ausgang der Erfassungsschaltung 500' verbunden.

Nach Abschluß des Taktzyklusses wird mittels der Rücksetzsignale R und Rᵣₛ sowohl die Eigenkapazität Cₙ der Strahlungssensorelements 100 als auch der erste Speicherkondensator C₁ zurückgesetzt.

Die gesamte Erfassungsschaltung 500, 500' kann gemäß dem fünften und sechsten Ausführungsbeispiel in einer Zelle, d.h. einem Pixel, der Strahlungssensoreinrichtung untergebracht sein. Die Zelle, das Pixel, gibt sich ändernde Stahlungssensorsignale zur Weiterverarbeitung aus und führt damit zu einer dramatischen Datenreduktion.

Durch die Taktsteuerung und die zerhackte Übertragung der Information, z.B. bei Photonenströmen (Licht), ist es möglich, sehr große Dynamikbereiche zu realisieren. Der einfallende Photonenstrom entspricht der Anzahl der Photonen pro Zeit.

Während bekannte Systeme Integrationszeiten oberhalb >lms aufweisen, ermöglicht die Vorrichtung gemäß dem fünften und sechsten Ausführungsbeispiel, bei der Zeitauflösungen bis in den µs Bereich möglich sind, auch eine Impulshöheninformation aus Einzelimpulsen zu übertragen und im nachfolgenden Verarbeitungssystem aufzuintegrieren. Dadurch wird ein hoher Dynamikbereich erreicht. Es sind dann Verarbeitungsbreiten in der Verarbeitungseinheit bis 24 Bit möglich, was dem vollen sichtbaren Lichtspektrum entspricht.

Welche Dynamik erhalten wird, ist verarbeitungsmäßig festlegbar, indem festgelegt wird, über wieviel Zyklen das gequantelte Pixelsignal in der Verarbeitungseinheit zu einem Datenwert zusammengesetzt wird. Durch dieses Verfahren ist sehr elegant die A/D-Wandlung vereinfacht und gleichzeitig wird eine Datenreduktion erreicht.

Das Schnittstellensystem zwischen Pixelmatrix und Verarbeitungseinheit wird dadurch um mehrere Größenordnungen bezüglich des Datenflusses entlastet.

Neue Videosysteme mit Bildwiederholungsfrequenzen für extrem schnelle Ereignisse und zur Prozeßsteuerung sind damit möglich. Gleichzeitig kann auf Blendensysteme verzichtet werden, da der Dynamikbereich hoch genug ist.

## Patentansprüche

1. Strahlungssensoreinrichtung zum Erfassen einer auf diese auftreffenden Strahlung, mit
zumindest einem Strahlungssensorelement (100), das einen durch die auftreffende Strahlungsleistung erzeugten Strom abgibt; und
einer Erfassungsschaltung, die den vom Strahlungssensorelement (100) erzeugten Strom erfaßt;
dadurch gekennzeichnet,
daß das Strahlungssensorelement (100) ein Transistor mit einem Gate-, einem Source-, einem Drain- und einem Substrat-Anschluß ist; und
daß die Strahlungssensoreinrichtung (200) eine Rücksetzschaltung (106, 108, 110, 112) umfaßt, die bei Anlegen eines Rücksetzsignals (R) eine Verbindung zwischen dem Substrat-Anschluß und dem Source-Anschluß des Transistors bewirkt, so daß die durch die auftreffende Strahlungsleistung erzeugten Ladungsträger mit einer Rate rekombinieren, die höher ist als die Rate ohne Rücksetzsignal (R), wobei das Rücksetzsignal (R) durch die Erfassungsschaltung an die Rücksetzschaltung anlegbar ist.

2. Strahlungssensoreinrichtung nach Anspruch 1, dadurch gekennzeichnet,
daß das Strahlungssensorelement (100) ein MOS-Transistor mit floatender Wanne ist.

3. Strahlungssensoreinrichtung nach Anspruch 1, dadurch gekennzeichnet,
daß das Strahlungssensorelement (100) ein J-FET ist.

4. Strahlungssensoreinrichtung nach Anspruch 1, dadurch gekennzeichnet,
daß das Strahlungssensorelement (100) ein SOI-Transistor ist.

5. Strahlungssensoreinrichtung nach Anspruch 2, dadurch gekennzeichnet,
daß die Rücksetzschaltung in der Wanne angeordnet ist.

6. Strahlungssensoreinrichtung nach einem der Ansprüche 1 bis 5, dadurch gekennzeichnet,
daß die Rücksetzschaltung einen FET-Schalter umfaßt.

7. Strahlungssensoreinrichtung nach einem der Ansprüche 1 bis 6, dadurch gekennzeichnet,
daß eine Eigenkapazität (Cₙ) des Strahlungssensorelements (100) die durch die eingefallene Strahlung erzeugten Ladungen speichert.

8. Strahlungssensoreinrichtung nach einem der Ansprüche 1 bis 7, dadurch gekennzeichnet,
daß die Erfassungsschaltung (200) folgende Merkmale aufweist:
- einen Kondensator (C), der zwischen einen Ausgang (104) des Strahlungssensorelements (100) und Masse geschaltet ist;
- einen Schalter (S), der in seinem geschlossenen Zustand den Kondensator (C) überbrückt;
- einen Puffer (202), dessen Eingang mit dem Ausgang (104) des Strahlungssensorelements (100) verbunden ist;
- einen Analog/Digital-Wandler (204), dessen Eingang mit dem Ausgang des Puffer (202) verbunden ist;
- eine Logikschaltung (206) mit einem Eingang (208) und drei Ausgängen (210, 212, 214), deren Eingang (208) mit dem Ausgang des Analog/Digital-Wandlers (204) verbunden ist und die abhängig von am Eingang (208) anliegenden Signalen am ersten und zweiten Ausgang (210, 212) das Rücksetzsignal (R) erzeugt und am dritten Ausgang (214) ein Ausgangssignal erzeugt, wobei der erste Ausgang (210) mit der Rücksetzschaltung verbunden ist, und der zweite Ausgang (212) mit dem Schalter (S) verbunden ist; und
- eine Flagspeichereinrichtung (216), die mit dem dritten Ausgang (214) der Logikschaltung (206) verbunden ist, die abhängig vom Ausgangssignal der Logikschaltung (206) und aus einem Vergleich eines vorhergehenden Wertes des Ausgangssignals mit dem anliegenden Ausgangssignal einen Zustand einer Flag einstellt und speichert.

9. Strahlungssensoreinrichtung nach Anspruch 8, dadurch gekennzeichnet,
daß der Schalter (S) ein FET-Schalter ist.

10. Strahlungssensoreinrichtung nach einem der Ansprüche 1 bis 7, dadurch gekennzeichnet,
daß die Erfassungsschaltung (200) folgende Merkmale aufweist:
- einen ersten Transistor (300), der zwischen einen Ausgang (104) des Strahlungssensorelements (100) und Masse geschaltet ist;
- einen zweiten Transistor (302), der mit dem Ausgang (104) des Strahlungssensorelements (100) verbunden ist;
wobei der erste und der zweite Transistor (300, 302) derart verschaltet sind, daß während der Rücksetzphase ein vom Strahlungssensorelement (100) ausgegebenes Signal auf Masse liegt, und daß während der Meßphase das Signal mit dem höchsten Pegel am Ausgang (304) anliegt; und
- einen Puffer (306), der mit dem Ausgang (304) des zweiten Transistors (302) verbunden ist und dessen Ausgang mit einem Ausgang der Erfassungsschaltung verbunden ist.

11. Strahlungssensoreinrichtung nach Anspruch 10, dadurch gekennzeichnet, daß
der erste Transistor (300) einen NMOS-Transistor aufweist, dessen Source mit dem Ausgang (104) des Strahlungssensorelements (100) verbunden ist, dessen Drain mit Masse verbunden ist, und an dessen Gate das Rücksetzsignal (R) anlegbar ist; und
der zweite Transistor (302) ein NMOS-Transistor in Diodenschaltung ist.

12. Strahlungssensoreinrichtung nach einem der Ansprüche 1 bis 7, dadurch gekennzeichnet,
daß die Erfassungsschaltung (200) folgende Merkmale aufweist:
- einen ersten Speicherkondensator (C₁), dessen erster Anschluß (402) mit dem Ausgang (104) des Stahlungssensorelements (100) verbunden ist, und dessen zweiter Anschluß (404) mit einer Leistungsversorgung (Vₛₛ) verbunden ist;
- einen ersten Rücksetzschalter (R₁), der parallel mit dem ersten Speicherkondensator (C₁) verschaltet ist;
- einen zweiten Speicherkondensator (C₂), dessen erster Anschluß (406) mit dem Ausgang (408) der Erfassungsschaltung (400) verbunden ist, und dessen zweiter Anschluß (410) mit der Leistungsversorgung (Vₛₛ) verbunden ist;
- einen zweiten Rücksetzschalter (R₂), der parallel mit dem zweiten Speicherkondensator (C₂) verschaltet ist;
- einen Komparator (K) mit einem Ausgang, dessen invertierender Eingang mit dem ersten Anschluß (402) des ersten Speicherkondensators (C₁) verbunden ist, und dessen nicht-invertierender Eingang mit dem ersten Anschluß (406) des zweiten Speicherkondensators (C₂) verbunden ist;
- einen Schalter (S₁), der in einer ersten Stellung den Ausgang (104) des Strahlungssensorelements (100) mit dem Ausgang (408) der Erfassungsschaltung (400) verbindet, wenn am Ausgang des Komparators (K) ein Signal anliegt, und der in seiner zweiten Stellung den Ausgang (104) von dem Ausgang (408) trennt, wenn am Ausgang des Komparators (K) kein Signal anliegt; und
- ein Register (REG), dessen Eingang (412) mit dem Ausgang des Komparators (K) verbunden ist, dessen Ausgang (414) mit einem Ausleseanschluß (416) der Erfassungsschaltung (400) verbunden ist, und das einen Rücksetzeingang (418) einschließt, der mit einem Rücksetzanschluß (R₃) der Erfassungsschaltung (400) verbunden ist, wobei das Register (REG) ein Auslesebit speichert, wenn am Ausgang des Komparators (K) ein Signal anliegt, wobei das Auslesebit zurückgesetzt wird, wenn am Rücksetzeingang (418) des Registers (REG) ein Rücksetzsignal anliegt.

13. Strahlungssensoreinrichtung nach Anspruch 12, dadurch gekennzeichnet,
daß die Rücksetzschalter (R₁, R₂) FET-Schalter sind.

## Claims

1. A radiation sensor means for detecting a radiation incident thereon, comprising
at least one radiation sensor element (100) outputting a current which is generated by the incident radiation power; and
a detection circuit detecting the current generated by the radiation sensor element (100);
characterized in that
the radiation sensor element (100) is a transistor having a gate, a source, a drain and a substrate terminal; and
that the radiation sensor means (200) comprises a reset circuit (106, 108, 110, 112), which, when it has a reset signal (R) applied thereto, establishes a connection between the substrate terminal and the source terminal of the transistor so that the charge carriers produced by the incident radiation power recombine at a rate which is higher than the rate without the reset signal (R), the reset signal (R) being adapted to be applied to said reset circuit by means of the detection circuit.

2. A radiation sensor means according to claim 1, characterized in that
the radiation sensor element (100) is an MOS transistor with a floating well.

3. A radiation sensor means according to claim 1, characterized in that
the radiation sensor element (100) is an JFET.

4. A radiation sensor means according to claim 1, characterized in that
the radiation sensor element (100) is an SOI transistor.

5. A radiation sensor means according to claim 2, characterized in that
the reset circuit is arranged in said well.

6. A radiation sensor means according to one of the claims 1 to 5, characterized in that
the reset circuit comprises an FET switch.

7. A radiation sensor means according to one of the claims 1 to 6, characterized in that
a self-capacitance (Cₙ) of the radiation sensor element (100) stores the charges generated by the incident radiation.

8. A radiation sensor means according to one of the claims 1 to 7, characterized in that
the detection circuit (200) has the following features:
- a capacitor (C) connected between an output (104) of the radiation sensor element (100) and ground;
- a switch (S) bridging the capacitor (C) in its closed condition;
- a buffer (202) whose input is connected to the output (104) of the radiation sensor element (100);
- an analog-digital converter (204) whose input is connected to the output of the buffer (202);
- a logic circuit (206) comprising an input (208) and three outputs (210, 212, 214), said logic circuit (206) having its input (208) connected to the output of the analog-digital converter (204) and producing the reset signal (R) at the first and second outputs (210, 212) in response to the signals applied to the input (208) and an output signal at the third output (214), the first output (210) being connected to the reset circuit and the second output (212) being connected to the switch (S); and
- a flag storage means (216) connected to the third output (214) of the logic circuit (206), said flag storage means (216) setting a status of a flag depending on the output signal of said logic circuit (206) and on a comparison between a preceding value of the output signal and the output signal applied, and storing said status of the flag.

9. A radiation sensor means according to claim 8, characterized in that
the switch (S) is an FET switch.

10. A radiation sensor means according to one of the claims 1 to 7, characterized in that
the detection circuit (200) has the following features:
- a first transistor (300) connected between an output (104) of the radiation sensor element (100) and ground;
- a second transistor (302) connected to the output (104) of the radiation sensor element (100);
said first and second transistors (300, 302) being interconnected such that, during the reset phase, a signal outputted by the radiation sensor element (100) is connected to ground and that, during the measurement phase, the signal having the highest level is applied to the output (304); and
- a buffer (306) connected to the output (304) of the second transistor (302), the output of said buffer (306) being connected to an output of the detection circuit.

11. A radiation sensor means according to claim 10, characterized in that
the first transistor (300) comprises an NMOS transistor whose source is connected to the output (104) of the radiation sensor element (100), whose drain is connected to ground and whose gate is adapted to have applied thereto the reset signal (R); and
that the second transistor (302) is an NMOS transistor connected in a diode connection.

12. A radiation sensor means according to one of the claims 1 to 7, characterized in that
the detection circuit (200) has the following features:
- a first storage capacitor (C₁) whose first terminal (402) is connected to the output (104) of the radiation sensor element (100) and whose second terminal (404) is connected to a power supply (Vₛₛ) ;
- a first reset switch (R₁) connected in parallel with said first storage capacitor (C₁) ;
- a second storage capacitor (C₂) whose first terminal (406) is connected to the output (408) of the detection circuit (400) and whose second output (410) is connected to the power supply (Vₛₛ) ;
- a second reset switch (R₂) connected in parallel with said second storage capacitor (C₂);
- a comparator (K) having an output, the inverting input of said comparator (K) being connected to the first terminal (402) of the first storage capacitor (C₁) and the non-inverting input of said comparator (K) being connected to the first terminal (406) of the second storage capacitor (C₂);
- a switch (S₁) which, at a first position, connects the output (104) of the radiation sensor element (100) to the output (408) of the detection circuit (400) when a signal is applied to the output of the comparator (K), and which, at its second position, separates the output (104) from the output (408) when no signal is applied to the output of the comparator (K); and
- a register (REG) whose input (412) is connected to the output of the comparator (K) and whose output (414) is connected to a read-out terminal (416) of the detection circuit (400), said register (REG) including a reset input (418), which is connected to a reset terminal (R₃) of the detection circuit (400), and storing a read-out bit when a signal is applied to the output of the comparator (K), said read-out bit being reset when a reset signal is applied to the reset input (418) of the register (REG).

13. A radiation sensor means according to claim 12, characterized in that
the reset switches (R₁, R₂) are FET switches.

## Revendications

1. Dispositif capteur de rayonnement pour détecter un rayonnement qui y est incident, comportant
au moins un élément capteur (100) de rayonnement, qui produit un courant engendré par la puissance de rayonnement incidente; et
un circuit de détection qui détecte le courant engendré par l'élément capteur (100) de rayonnement;
caractérisé
en ce que l'élément capteur (100) de courant est un transistor qui comporte une borne de grille, une borne de source, une borne de drain et une borne de substrat; et
en ce que le dispositif capteur (200) de rayonnement comprend un circuit de restauration (106, 108, 110, 112) qui établit une liaison entre la borne de substrat et la borne de source du transistor lors de l'application d'un signal de restauration (R), de façon que les porteurs de charge engendrés par la puissance de rayonnement incidente se recombinent à une cadence qui est supérieure à la cadence sans signal de restauration (R), le signal de restauration (R) pouvant être appliqué au circuit de restauration par le circuit de détection.

2. Dispositif capteur de rayonnement selon la revendication 1, caractérisé en ce que
l'élément capteur (100) de rayonnement est un transistor MOS à cuvette flottante.

3. Dispositif capteur de rayonnement selon la revendication 1, caractérisé en ce que
l'élément capteur (100) de rayonnement est un transistor unijonction à effet de champ , ou U-FET.

4. Dispositif capteur de rayonnement selon la revendication 1, caractérisé en ce que
l'élément capteur (100) de rayonnement est un transistor à silicium polycristallin sur isolant, ou SOI.

5. Dispositif capteur de rayonnement selon la revendication 2, caractérisé en ce que
le circuit de restauration est agencé dans la cuvette.

6. Dispositif capteur de rayonnement selon l'une des revendications 1 à 3, caractérisé en ce que
le circuit de restauration comprend un commutateur FET.

7. Dispositif capteur de rayonnement selon l'une des revendications 1 à 6, caractérisé en ce que
la capacité propre (Cₙ) de l'élément capteur (100) de rayonnement accumule les charges engendrées par le rayonnement incident.

8. Dispositif capteur de rayonnement selon l'une des revendications 1 à 7, caractérisé en ce que
le circuit de détection (200) présente les caractéristiques suivantes:
- un condensateur (C) qui est connecté entre une sortie (104) de l'élément capteur (100) de rayonnement et la masse;
- un commutateur (S) qui shunte le condensateur (C) lorsqu'il est dans son état fermé;
- un tampon (202) dont l'entrée est reliée à la sortie (104) de l'élément capteur (100) de rayonnement;
- un convertisseur (204) d'analogique à numérique, dont l'entrée est reliée à la sortie du tampon (202);
- un circuit logique (106) à une entrée (208) et trois sorties (210, 212, 214), dont l'entrée (208) est reliée à la sortie du convertisseur (204) d'analogique à numérique et qui engendre le signal de restauration (R) à la première ou à la deuxième sortie (210, 212) en fonction de signaux présents à l'entrée (208) et engendre un signal de sortie à la troisième sortie (214), la première sortie (210) étant reliée au circuit de restauration et la deuxième sortie (212) étant reliée au commutateur (S); et
- un dispositif de mémoire (216) de drapeau qui est relié à la troisième sortie (214) du circuit logique (206), qui établit et mémorise un état d'un drapeau en fonction du signal de sortie du circuit logique (206) et d'une comparaison d'une valeur précédente du signal de sortie avec le signal de sortie actuel.

9. Dispositif capteur de rayonnement selon la revendication 8, caractérisé en ce que
le commutateur (S) est un commutateur FET.

10. Dispositif capteur de rayonnement selon l'une des revendications 1 à 7, caractérisé en ce que
le circuit de détection (200) présente les caractéristiques suivantes:
- un premier transistor (300) qui est connecté entre une sortie (104) de l'élément capteur (100) de rayonnement et la masse;
- un deuxième transistor (302) qui est relié à la sortie (104) de l'élément capteur (100) de courant;
- le premier et le deuxième transistors (300, 302) étant montés d'une manière telle qu'un signal produit par l'élément capteur (100) de rayonnement est à la masse pendant la phase de restauration et que le signal au niveau le plus élevé est présent à la sortie (304) pendant la phase de mesure; et
- un tampon (306) qui est relié à la sortie (304) du deuxième transistor (302) et dont la sortie est reliée à une sortie du circuit de détection.

11. Dispositif capteur de rayonnement selon la revendication 10, caractérisé en ce que
le premier transistor (300) comprend un transistor NMOS, dont la source est reliée à la sortie (104) de l'élément capteur (100) de rayonnement, dont le drain est relié à la masse, et à la grille duquel le signal de restauration (R) peut être appliqué; et
le deuxième transistor (302) est un transistor NMOS monté en circuit de diode.

12. Dispositif capteur de rayonnement selon l'une des revendications 1 à 7, caractérisé en ce que
le circuit de détection (200) présente les caractéristiques suivantes:
- un premier condensateur d'accumulation (C₁) dont la première borne (402) est reliée à la sortie (104) de l'élément capteur (100) de rayonnement et dont la deuxième borne (404) est reliée à une alimentation en énergie (Vₛₛ) ;
- un premier commutateur de restauration (R₁) qui est monté en parallèle au premier condensateur accumulateur (C₁) ;
- un deuxième condensateur d'accumulation (C₂) dont la première borne (406) est reliée à la sortie (408) du circuit de détection (400) et dont la deuxième borne (410) est reliée à l'alimentation en énergie (Vₛₛ) ;
- un deuxième commutateur de restauration (R₂) qui est monté en parallèle au deuxième condensateur accumulateur (C₂);
- un comparateur (K) à une sortie, dont l'entrée à inversion est raccordée à la première borne (402) du premier condensateur accumulateur (C₁) et dont l'entrée sans inversion est reliée à la première borne (406) du deuxième condensateur accumulateur (C₂) ;
- un commutateur (S₁) qui relie dans une première position la sortie (104) de l'élément capteur (100) de rayonnement à la sortie (408) du circuit de détection (400), lorsqu'un signal est présent à la sortie du comparateur (K), et qui déconnecte la sortie (104) de la sortie (408) dans sa deuxième position, lorsqu'aucun signal n'est présent à la sortie du comparateur (K);
- un registre (REG) dont l'entrée (412) est reliée à la sortie du comparateur (K), dont la sortie (414) est reliée à une borne de lecture (416) du circuit de détection (400) et qui inclut une entrée (418) de restauration qui est reliée à une borne (R₃) de restauration du circuit de détection (400), le registre (REG) mémorisant un bit de lecture lorsqu'un signal est présent à la sortie du comparateur (K), le bit de lecture étant restauré lorsqu'un signal de restauration est présent à l'entrée de restauration (418) du registre (REG).

13. Dispositif capteur de rayonnement selon la revendication 12, caractérisé en ce que
les commutateurs de restauration (R₁, R₂) sont des commutateurs FET.
